# EUROPEAN PATENT SPECIFICATION

(11) **EP 2 751 841 B1**
(45) Date of publication and mention of the grant of the patent: **05.08.2015**
(21) Application number: 12758657.6
(22) Date of filing: 31.08.2012
(51) Int. Cl.: H01L 31/0224, H01L 31/0352

(54) **INTERDIGITATED BACK CONTACT PHOTOVOLTAIC CELL WITH FLOATING FRONT SURFACE EMITTER REGIONS**
INEINANDERGREIFENDER RÜCKSEITENKONTAKT EINER FOTOVOLTAIKZELLE MIT VORDERSEITIGEN FLOATING-EMITTERREGIONEN
PILE PHOTOVOLTAÏQUE À CONTACT POSTÉRIEUR INTERDIGITÉ PRÉSENTANT DES RÉGIONS D'ÉMETTEUR DE SURFACE AVANT FLOTTANTES

(30) Priority: 02.09.2011 NL 2007344
(43) Date of publication of application: 09.07.2014
(73) Proprietor: Stichting Energieonderzoek Centrum Nederland, 1755 LE Petten (NL)
(72) Inventor: CESAR, Ilkay, NL-1733 LE Petten (NL)
(74) Representative: Jansen, Cornelis Marinus
(86) International application number: PCT/NL2012/050601
(87) International publication number: WO 2013/032335

(56) References cited:
- US-A- 4 665 277
- US-A1- 2011 162 703
- J. ROBBELEIN ET AL: "Towards advanced back surface fields by boron implantation on p-type interdigitated back junction solar cells", 25ND EUROPEAN PHOTOVOLTAIC SOLAR ENERGY CONFERENCE, PROCEEDINGS OF THE 25ND INTERNATIONAL CONFERENCE, WIP-RENEWABLE ENERGIES, 6 September 2010 (2010-09-06), pages 2014-2018, XP040531133, Valencia, Spain ISBN: 978-3-936338-26-3
- T.NAGASHIMA ET AL: "Efficiency improvements of back-contact type photovoltaic solar cells by a floating emitter", 20TH EUROPEAN PHOTOVOLTAIC SOLAR ENERGY CONFERENCE, PROCEEDINGS OF THE 20TH INTERNATIONAL CONFERENCE, WIP-RENEWABLE ENERGIES, 6 June 2005 (2005-06-06), pages 163-166, XP040511380, Barcelona, Spain ISBN: 978-3-936338-19-5

## Description

### Field of the invention

The invention relates to a photovoltaic cell and a method of manufacturing such a cell.

### Background

An interdigitated back contact photo-voltaic cell has base and emitter regions on the same surface of the photo-voltaic cell (conventionally called the back surface). As is known per se, operation of a photo-voltaic cell is based on light induced excitation of free charge carriers in a semi-conductor substrate. The base and emitter regions are regions of mutually opposite conductivity type that collect majority and minority charge carriers from the semi-conductor substrate respectively.

Documents J. Robbelein et al., Proceedings of the 25th European photovoltaic energy conference, WIP-Renewable energies, 6 September 2010, pages 2014-2018, discloses photovoltaic cells and related manufacturing methods.

Two different basic photo-voltaic cell designs can be distinguished: designs in which the base and emitter regions are provided on mutually opposite surfaces of the semi-conductor substrate and interdigitated designs, in which the base and emitter regions are provided on the same surface of the substrate (the back surface). In interdigitated designs, the contacts to the base and emitter regions are usually also provided on the back surface. The contacts may be realized by means of broad bus bar connections on opposite sides of the back surface and sets of parallel conductor tracks on the base and emitter regions respectively, connected to respective ones of the bus bars. In opposite surface designs, the contacts to the base and emitter regions may be on the same surface as the base and emitter region respectively, or they may both be on the same surface, using vias through the substrate to couple the base or emitter region to contact pads on the other surface.

When an interdigitated design with base and emitter regions on the same surface is used, the opposite surface (called the front surface) may be covered by a region that has a doping level that differs from that of the semi-conductor substrate. In many known photo-voltaic cells with interdigitated back surface design, the front surface is covered with an electrically floating surface field region that has an enhanced doping level of the same conductivity type as the semi-conductor substrate, like the base regions on the back surface. Such a surface field region reduces recombination at the front surface, because it depresses minority charge carrier density at the front surface.

Page 160 of a thesis by F.Granek (2009), titled high-efficiency back-contact back-junction silicon solar cells" figure 9-1(b) discloses a photo-voltaic cell having a front surface covered by a region of doping of the opposite polarity type compared to the semi-conductor substrate. This is proposed as a passivation scheme which reduces recombination, because it depresses the density of majority charge carriers from the substrate at the front surface. Granek (page 145) mentions that a floating emitter layer on the front surface has a pumping effect wherein minority carriers that are photo-generated in large lateral distances from the emitter, are injected to the floating emitter, where they become majority carriers. The lateral flow of these carriers in the floating emitter is enhanced. Next, the carriers are re-injected into the base and diffuse vertically to the p-n junction. Thus, the pumping effect of the floating emitter reduces the electrical shading losses in the back-contact back-junction. However, the document does not disclose an efficiency gain and even a loss at low light intensities. Figure 9.6 of the thesis by F.Granek (page 167) shows that the external quantum efficiency (EQE) decreases with decreasing light intensity. This is attributed to leakage current of charge carriers from front emitter layer into the underlying substrate where they are minority charge carriers that recombine with majority charge carriers. This type of loss occurs mainly in the regions overlying the base regions.

Interdigitated designs have the advantage that they avoid the problem of optical shading of the semi-conductor substrate by connection structures on the front surface. However, interdigitated designs suffer from an effect called electrical shading. Minority charge carriers generated in the semi-conductor substrate adjacent the base regions have to move laterally towards an emitter region before they can be collected. With increasing distance from the emitter regions it is increasingly likely that such charge carriers will recombine rather than that they reach the emitter region, which leads to a loss of net useful output power. This problem is addressed by reducing the width of base regions to a minimum. However, reduction of feature widths makes the manufacturing process more complicated.

### Summary

Among others, it is an object to provide for a photo-voltaic cell with interdigitated base and emitter regions wherein wider base regions can be used with reduces loss due to electrical shading.

Interdigitated back contact photovoltaic cell with floating front surface emitter regions is provided. A photo-voltaic cell according to claim 1 is provided. Herein, patterns with a combination of regions of mutually opposite conductivity type are provided on both the front and back surface of the semi-conductor substrate (as used herein "regions on the semi-conductor substrate" refers both to embodiments wherein the regions are part of the semi-conductor substrate near its surfaces and embodiments wherein the regions are parts of a layer or layers applied on the surfaces). The conductivity type of the regions may be created by doping and/or by an external field generation structure that induces an inversion layer, much like an inversion layer can be created underneath a gate in a field effect transistor. The external field generation structure may comprise a charged layer for example.

The regions of mutually opposite conductivity type on the back surface are used as base and emitter regions or vice versa, electrically connected to the output terminals of the photo-voltaic cell. The regions of mutually opposite conductivity type on the front surface are electrically floating regions, i.e. regions without electrical connection to the output terminals other than through the material of the substrate. Regions on the front surface with the conductivity type of the emitter regions at least partly overlap with the base regions on the back surface, when viewed in projection along a direction perpendicular to the back surface. In this way, these regions on the front surface with the conductivity type of the emitter provide for a lateral current path from the area over the base regions towards the emitter regions. Minority charge carriers from the bulk of the semi-conductor substrate over the base regions that travel laterally along this path are majority charge carriers in the region of the front surface with the conductivity type of the emitter, which reduces recombination loss. In an embodiment, the front surface regions with the conductivity type of the base may have enhanced doping relative to the semi-conductor substrate.

In an embodiment an electrically floating conductor line on at least one of the surface regions of the front surface that have the conductivity type of the emitter, extending transverse to an edge of the surface region. In this way a further lateral current path is provided that reduces recombination loss even further.

In an embodiment wherein the front surface has textured height variations, a layer of aluminium oxide is provided on the textured structure. This reduces recombination loss where the surface region with the conductivity type of the emitter may be punctured due to the texture.

### Brief description of the drawing

These and other objects and advantageous aspects will become apparent from a description of exemplary embodiments with reference to the following figures.
- Figure 1: shows a schematic cross-section through a photo-voltaic cell
- Figure 1a: shows a schematic cross-section through a photo-voltaic cell
- Figure 2: shows a schematic top view of part of the back surface
- Figure 3: shows a schematic top view of part of the front surface
- Figure 4: shows a flow chart of a manufacturing process
- Figure 5, 6: show a side view of a textured front surface
- Figure 7: shows a top view of an embodiment of the front surface

### Detailed description of exemplary embodiments

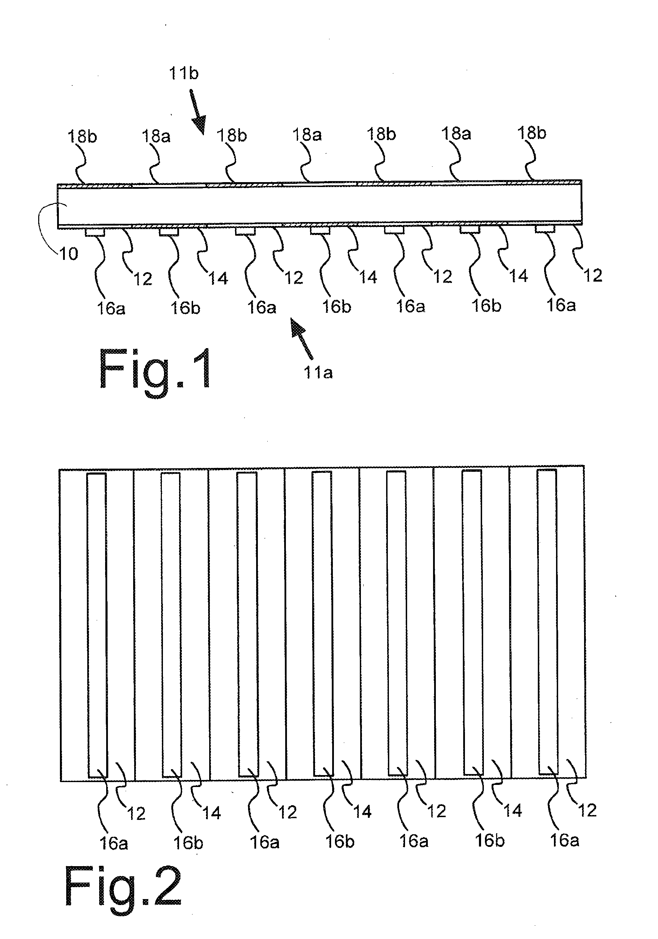

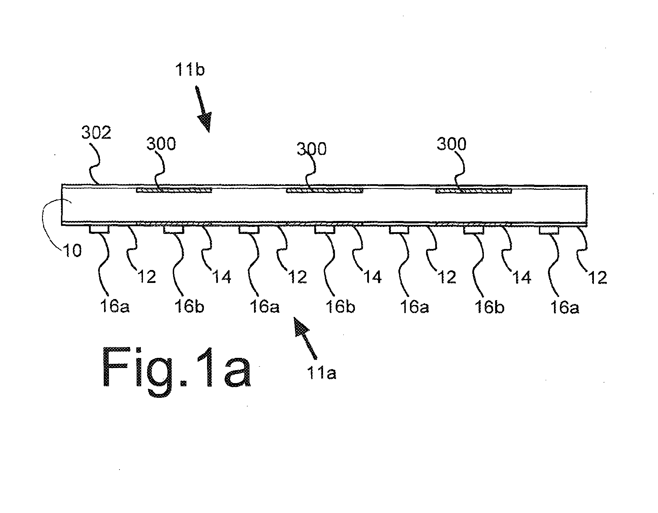

Figure 1 shows a schematic cross-section through a photo-voltaic cell, comprising a semi-conductor substrate 10, with a first and second surface 11a,b, base regions 12 and emitter regions 14 on the first surface 11a, first and second conductor lines 16a, b on base regions 12 and emitter regions 14 respectively and further regions 18a,b of mutually opposite conductivity type on second surface 11b.

Semi-conductor substrate 10 may be made of silicon for example, doped to have a first conductivity type (n-type or p-type) and having a thickness D in a range of 0.01- 1000 micrometer and more preferably from 1-200 micrometer, which forms the distance between first and second surface 11a,b. First and second surface 11a,b of semi-conductor substrate 10 will be referred to as the back surface and the front surface respectively, because the latter will be directed facing the sun, or other light energy source, during operation and the former will be directed facing away from the sun or other light energy source. First and second surface 11a,b may be flat planar surfaces parallel to each other.

Figure 2 a schematic top view of part of the back surface of a photo-voltaic cell, showing base regions 12 and emitter regions 14 and first and second conductor lines 16a, b. The schematic cross-section of figure 1 is shown along a width direction W of base regions 12 and emitter regions 14. Base regions 12 and emitter regions 14 may have elongated shape, with a width in the width direction W that is considerably smaller that a length in a length direction transverse to the width direction W (formally a width direction at point on an edge is the direction from that point through the region to nearest point to that point on an opposite edge). The value of the width of the base regions 12 in the width direction may be in a range of 0.1 - 4000 micrometer for example, preferably 0.5 to 4 millimeter the value of their length being at least 50 millimeter, dependent on the size of the cell. The value of the width of the emitter regions 14 in the width direction may be in a range of 0.1- 4000 micrometer for example, preferably 0.5 to 4 millimeter, for example the same as that of base regions 12 the value of their length being at least 50 millimeter, dependent on the size of the cell.

Base regions 12 have the first conductivity type, i.e. the same conductivity type as semi-conductor substrate 10. Base regions 12 may be regions of a surface field layer with enhanced doping of the first conductivity type compared to the semi-conductor substrate 10. Emitter regions 14 have a second conductivity type, opposite to the first conductivity type, for example p-type if semi-conductor substrate has n-type conductivity, so that a semi-conductor junction is present at the interface of semi-conductor substrate 10 and emitter regions 14. Base regions 12 may have a thickness within in a range of 0.1 nanometer - 100 micron for example, or less than 10% of the thickness of substrate 10 for example. Emitter regions 14 may have a thickness within in a range of 0.1nanometer - 100micron for example , or less than 10% of the thickness of substrate 10 for example. Base regions 12 and emitter regions 14 may be parts of semi-conductor substrate 10 adjacent its surface, with locally added doping, or they may be formed by doped layers on the surface semi-conductor substrate 10, or a combination of parts of semi-conductor substrate 10 and a layer or layers on semi-conductor substrate 10.

First and second conductor lines 16a, b are in electric contact with base regions 12 and emitter regions 14 respectively. First and second conductor lines 16a, b may be printed conductor lines of sintered grains of conductor material for example. First and second conductor lines 16a, b have an elongated (linear) shaped with a longest direction transverse to the width direction of base regions 12 and emitter regions 14. Figure 1 shows a cross-section of first and second conductor lines 16a, b in a virtual plane transverse to the length of first and second conductor lines 16a, b.

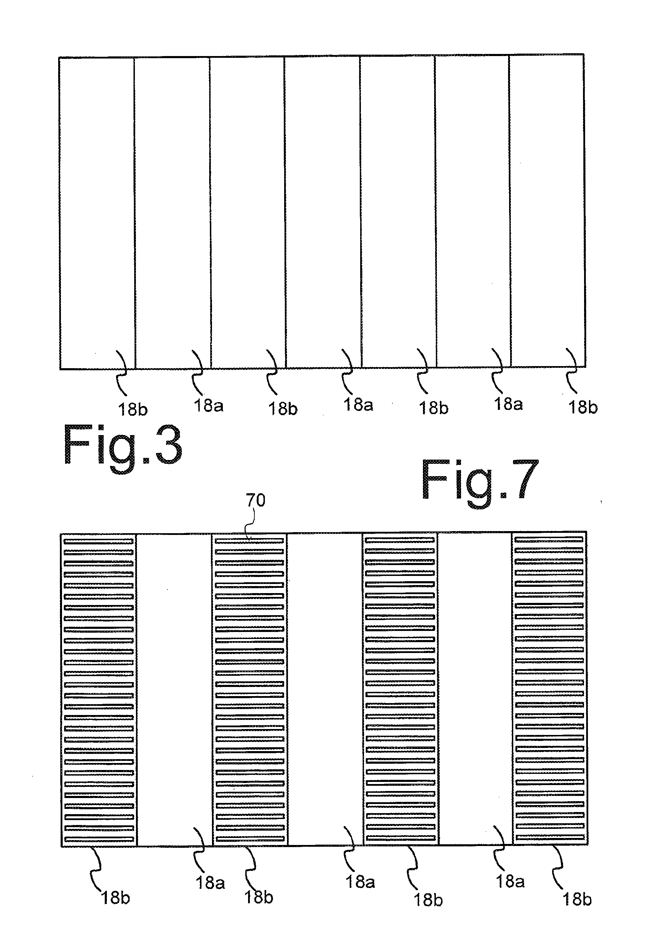

Figure 3 shows a schematic top view of part of the front surface of a photo-voltaic cell, showing first and second further regions 18a,b. First and second further regions 18a,b are provided in patterned way, so that neither covers the entire front surface. First further regions 18a have the first conductivity type, i.e. the same conductivity type as semi-conductor substrate 10, e.g. n type if the semi-conductor substrate 10 is n type. Second further regions 18b have the second conductivity type, i.e. the same conductivity type as emitter regions 14 on the back surface, e.g. p type if the semi-conductor substrate 10 is n type.

In the illustrated embodiment, first and second further regions 18a, b have the same layout as the emitter regions 14 and the base regions 12 on the back surface respectively. First further regions 18a are located facing emitter regions 14, i.e. their outlines coincide in projection in a direction perpendicular to the front and back surfaces. Second further regions 18b are located facing base regions 12, i.e. their outlines coincide in said projection in the direction perpendicular to the front and back surfaces. Further regions 18a,b may be parts of semi-conductor substrate 10 adjacent its surface, with locally added doping, or they may be formed by doped layers on the surface semi-conductor substrate 10, or a combination of parts of semi-conductor substrate 10 and a layer or layers on semi-conductor substrate 10. In the illustrated embodiment, no conductor lines are electrically coupled to the further regions 18a,b, if one disregards theoretical coupling through semi-conductor substrate 10.

Although not shown, the photo-voltaic cell may comprise further layers, such as dielectric layers etc. First and second conductor lines 16a, b may be coupled to base regions 12 and emitter regions 14 through such a dielectric layer for example.

Figures 2 and 3 show an example without bus bars. A bus bar is a relatively wide conductor line on the back surface to which a plurality of less wide conductor lines on the back surface are connected. A wider bus bars may be made unnecessary because wide base regions can be used owing to the use of the further regions on the front surface. However, it should be appreciated that bus bars may still be used. In this case, when a bus bar is provided on a base region at the back surface, a correspondingly wide second further region may be used on the front surface overlying the bus bar.

Although the figures show an example of elongated rectangular strip shaped base and emitter regions, it should be appreciated that regions of other shapes may be used. In one example base regions in the form of islands within emitter regions may be used, with corresponding islands of further second surface regions of the second conductivity type on the front surface. This makes it possible to reduce the total used area of further second surface regions, which may increase efficiency. Because the further second surface regions make it possible to use wider base regions without large efficiency loss, the base region islands can easily be connected by additional conductors.

In operation, one type of movable charge carrier (electrons or holes) is in the majority in semi-conductor substrate 10 (in an n-type substrate electrons are majority charge carriers and in a p-type substrate holes are majority charge carriers). In emitter regions 14 and second further regions 18b, the other type of charge carrier is in the majority. At semi-conductor junctions between the semi-conductor substrate 10 on one hand and emitter regions 14 and second further regions 18b on the other hand, spatial charge distribution gives rise to electric fields across the junctions. These electric fields keep down diffusive majority charge carrier current through the junctions. The electric fields have the effect of making the net current through the junctions zero when there is no output current through the terminals of the photo-voltaic cell. The electric field across the junctions between semi-conductor substrate 10 and emitter regions 14 is increased so that a net current arises when output current is drawn from the photovoltaic cell. Light that enters semi-conductor substrate 10 excites pairs of movable electron-holes. The majority charge carriers flow to base regions 12 and the minority charge carriers flow to emitter regions 14, where they are attracted by the electric field. Minority charge carriers that are excited in semi-conductor substrate 10 adjacent base regions 12 (i.e. at a location whose projection onto the back surface along a direction perpendicular to the back surface lies within the projection of the base regions 12), have to be transported laterally (in a direction parallel to the back surface) before they can reach an emitter region 14.

Second further regions 18b operate to reduce recombination loss during this lateral transport. Minority charge carriers from semi-conductor substrate 10 (e.g. holes in the case of an n-type semi-conductor substrate) that reach second further regions 18b will be drawn into these second further regions 18b by the electric field. This gives rise to a minority charge carrier density gradient in semi-conductor substrate 10. In turn this density gradient leads to a net diffusive flow of minority charge carriers that have been excited in semi-conductor substrate 10 adjacent base regions 12. In principle, this will result in a build up of charge in second further regions 18b until the effect of the resulting electric field (change of potential of second further regions 18b) balances the net flow. A similar effect occurs at emitter regions 14, except that here the build up of the electric field is less because second conductor lines 16b remove charge from emitter regions 14 in the form of output power from the photo-voltaic cell.

Second further regions 18b extend over locations on the front surface that overly base regions 12 on the back region. The edges of second further regions 18b overly the edges of emitter regions 14. Preferably second further regions 18b slightly extend beyond the edges from positions overlying base regions 12 to positions overlying emitter regions 14. (preferably with an overlap area between 0 and 40% of the emitter area and more preferably between 0 -20%). Second further regions 18b of the second conductivity type may have the effect that passivation is reduced. By avoiding the use of parts of second further regions 18b that extend over the entire emitter regions 14, and preferably nor more than 50% a gain due to decreased recombination over the base areas can be realized while avoiding decreased passivation at the surface above emitter areas 14.. In an embodiment second further regions 18b do not even extend to the positions overlying the edges emitter regions 14 but terminate within the area overlying base regions 12, slightly short of the edges of the emitter regions 14, so that the second further regions 18b has locations that are close to emitter regions 14, but not over them.

Where second further regions 18b and emitter regions 14 are close to each other, i.e. near their edges (whether they overlap with emitter regions 14 or not) the majority charge carriers of these regions (the minority charge carriers of semi-conductor substrate 10) cross over from second further regions 18b to emitter regions 14. Basically, where the regions are close to each other, the second further region 18b, the semi-conductor substrate 10 and the emitter regions 14 function as a bipolar transistor structure, second further regions 18b forming the collector of this transistor, emitter regions 14 forming the emitter of this transistor and the adjacent part of substrate 10 forming the base. At the edges of second further regions 18b charge carriers from second further regions 18b flow like a collector emitter current to emitter regions 14 Here the electric fields across the junctions differ from the fields at a greater distance from the edges, due to the proximity of the junctions to second further regions 18b and emitter regions 14 to semi-conductor substrate 10. The electric field at the edges does not balance net diffusive flow of majority charge carriers of second further regions 18b (holes in the case of a p-type second further region 18b and n-type substrate 10) to semi-conductor substrate 10. In semi-conductor substrate there is a net diffusive flow of these charge carriers to the nearby emitter region 14, where they are drawn in by the electric field across the junction.

The net flow of majority charge carriers from second further regions 18b near their edges results in a net lateral current through the second further regions 18b. Thus a current path arises for minority charge carriers from semi-conductor substrate 10 to second further regions 18b, then laterally through second further regions 18b to the edges of second further regions 18b and from there to emitter regions 14 via substrate 10. In second further regions 18b these charge carriers form the majority, so that they flow in the lateral direction with little or no loss due to recombination. Compared to lateral minority charge carrier current through semi-conductor substrate 10 less loss occurs in this current path due to recombination and the net output power from the photo-voltaic cell is increased.

In particular, when second further regions 18b are used, the width of base regions 12 can be increased without as much loss due to electrical shading as when no second further regions 18b are used. Hence wider base regions 12 can be used. This makes it possible to use less complicated process steps to realize base regions 12. The base regions can be made wider than the width of base contacts for current between the base regions and external connections. This makes it possible to provide for contacts on the conductor lines 16a on the base regions for supplying current from the photo-voltaic cell to external outputs or to other photo-voltaic cells, without requiring further measures to prevent short circuit from the base contacts to emitter regions 14.

Although by way of example a photovoltaic cell has been described wherein the outlines of the second further region 18b and the base region 12 coincide when seen in a projection along a direction normal to the back surface, it should be appreciated that such a coincidence is not strictly necessary. A second further region 18b that extends beyond the outline of base region 12 (when seen in said projection) may be used for example. The extension with an overlap in a range of 1-40% but preferably 1-20% of the width of the emitter areas may be used for example. Extension may increase net output power from the photo-voltaic cell as it provides for a wider region where majority charge carriers of second further region 18b can cross to emitter regions 14 and hence a lower current density and build up of electric field. However, as noted, overlap between second further regions 18b and emitter regions also leads to an increased need to charge second further region 18b. Hence it is preferred that the overlap is limited for example to less than 10% of the emitter regions 14. In another example base region 12 may extend beyond the outline of second further region 18b (when seen in said projection), e.g. by up to 0.2 millimeter. This has the effect that the majority charge carriers from second further region 18b will have to cross from second further region 18b to emitter region 14 over a longer distance through semi-conductor substrate 10, where they form minority charge carriers that are exposed to a greater risk of recombination. However, as long as second further region 18b reduces the total path length as minority charge carrier compared to the situation where no second further region 18b is provided, recombination loss may be reduced.

First further regions 18a primarily serve to reduce recombination at the front surface by depressing minority charge carrier density at the front surface. If the level of recombination at the front surface without such a front surface field is acceptable, or if the front surface is passified in another way, enhanced doping of first further regions 18a could be omitted, so that first further regions 18a would have the same doping density as semi-conductor substrate 10. However, when not needed for passivation enhanced doped first further regions 18a could be added because they may contribute an effect that is related to the effect of second further regions 18b. Enhanced doping in first further regions 18a has the effect that a part of the lateral majority charge carrier current is concentrated in first further regions 18a, which reduces recombination due to diffusion into emitter regions 14 or in semi-conductor substrate 10.

Although in the previous embodiments second further regions 18b were realized by a doped layer of the second conductivity type, it should be noted that instead a patterned external field generation structure may be used to create and inversion layer.

Creation of an inversion layer by means of an external field structure is known per se form field effect transistors, where a gate electrode on the surface of a semi-conductor body is used to generate an electric field that drives away majority charge carriers from a surface layer and attracts minority charge carriers so that the minority charge carriers of the bulk of the substrate become the majority in the surface layer. A precharged floating gate (e.g. embedded in a dielielectric layer as known from floating gate transistors in EPROMS) may be used on the surface of the semi-conductor substrate in the photo-voltaic cell. Optically transparent materials may be used for the floating gate. Alternatively, a permanently polarized layer may be used, e.g., a ferroelectric layer. Preferably external field generation structure is made using material that naturally collects a net charge, such as aluminium oxide or hafnium oxide if negative charge is wanted (on an n-type substrate, in order to create an inversion layer where positive charge carriers form the majority), or silicon nitride or silicon oxide if a positive charge is wanted.

Figure 1a shows an embodiment with a patterned external field generation structure on the front surface at the location of second further regions 18b. The patterned external field generation structure comprises patterned surface regions 300 and a charged layer 302. Patterned surface regions 300 in semi-conductor substrate 10 have enhanced doping density of the first conductivity type compared to the doping density of the bulk of the semi-conductor substrate. Patterned surface regions 300 are located in the semi-conductor substrate 10 at the positions of the first surface regions. Charged layer 302 covers the front surface both at the locations of the first and second surface regions. Charged layer 302 may be made of a material that naturally collects a net charge, such as aluminium oxide or hafnium oxide if negative charge is wanted (on an n-type substrate, in order to create an inversion layer where positive charge carriers form the majority), or silicon nitride or silicon oxide if a positive charge is wanted.

The patterned external field generation structure is used to create an inversion layer at the surface of substrate 10. At locations outside patterned surface regions 300, the field generated by charged layer 302 creates an inversion by driving away majority carriers and attracting minority carriers, creating a minority carrier channel. At locations within patterned surface regions 300, the enhance doping prevents inversion. As will be realized, the combination of the doping density and charge density of charged layer 302 may be selected to ensure this effect. It should be appreciated that figure 1a shows only one example of a patterned external field generation structure. In other examples a patterned charged layer may be used, for example with charged regions on the front surface selectively over base regions 12 to repel majority charge carriers. In this case a patterned or unpatterned layer of enhanced doping may be used.

Although the patterned external field generation structure is shown as an alternative for doped surface regions of the second conductivity type, it should be appreciated that the two may be combined. This can be used to enhance charge carrier density of the second conductivity type, or to overcome local defects.

It should be appreciated that a similar patterned charged layer, but with charges of the opposite sign, may be used to create base regions on the front surface instead of by means of doping. Also on the back surface a patterned charged layer or layers may be used instead of, or in addition to, the doped layers.

The photovoltaic cell may be manufactured using a process that is derived from manufacturing processes for manufacturing a solar cell with an interdigitated back surface design, with the added steps of creating a pattern of first and second further regions 18a,b on the front surface.

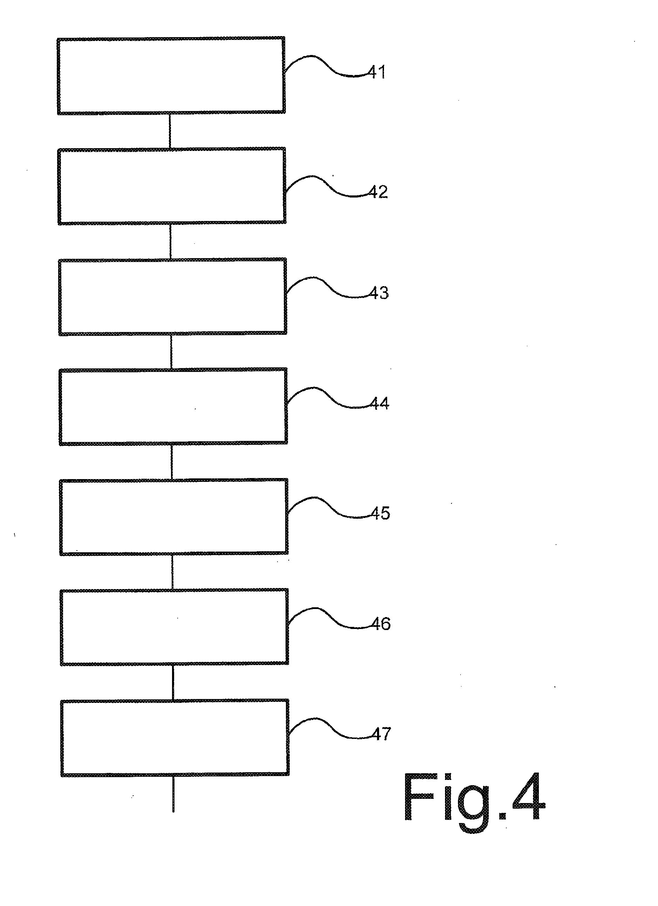

Figure 4 shows a flow chart of a process of manufacturing the photo-voltaic cell. The process involves steps of creating of patterned doped layers. Processes for doing so are known per se and will therefore not be described in detail. Patterned doped layers may be created for example by first doping a surface layer for example by means of implantation and/or by diffusion of dopant material from a source at the surface and afterwards removing the doped layer selectively where it is not needed, e.g. by depositing a patterned mask layer on the surface that leaves the surface exposed where the doped layer is not needed and subsequently etching the surface where it is exposed. As another example a patterned mask layer may be provided that exposes region may be provided first and the patterned doping may be applied, application being blocked by the mask layer where it does not expose the surface. In yet other embodiments a doped layer may be deposited on the surface of the substrate, in a patterned way, or in a process where the layer is subsequently removed in a patterned way. It should be emphasized that only one possible process is described by way of example.

In the exemplary process of the figure a substrate (wafer) with homogeneous doping of a first conductivity type is provided, for example n-type. The substrate may be subjected to various preparatory processing steps.

In first step 41, doping material of a second conductivity type opposite the first conductivity type (e.g. p-type) is added to a surface layer at the front surface of the substrate, for example by implantation and activation, or by applying a temporary source layer and causing dopant to diffuse from the source layer.

In second to fourth steps 42-44 a pattern of doped layers is created on the back surface. In a second step 42 doping material of the second conductivity type is added to a surface layer at the back surface of the substrate, facing the front surface. In a third step 43 a first patterned mask layer is provided on the back surface, exposing the back surface at the locations of base regions 12. This may be done by means of screen printing or by means of photolithographic techniques for example. In a fourth step 44 a layer with doping of the second conductivity is etched from the exposed base regions and subsequently doping material of the first conductivity type (e.g. n-type) is added in the exposed areas. Hereafter, the first mask layer is removed.

In fifth to fourth steps 42-44 a pattern of doped layers is created on the back surface. In a fifth step 45 a second patterned mask layer is provided on the front surface, exposing the front surface at the locations of first further regions 18a,. In a sixth step 46 doping material of the first conductivity type (e.g. n-type) is added in the exposed areas, with such a density that the net conductivity type of the surface layer in these areas will become the first conductivity type (e.g. n-type if substrate 10 is n-type) at a higher net first conductivity type doping density than in substrate 10 below the surface layer. Subsequently the second mask layer is removed.

In a seventh step 47 first and second conductor lines 16a, b are applied on the base and emitter regions on the back side. This may involve first creating a dielectric layer on the back surface, printing paste of conductor material on this dielectric layer at the intended locations of first and second conductor lines 16a, b and firing the cell to sinter the paste and to create a connection through the dielectric layer.

Subsequently, further processing steps, symbolized by a seventh step 47 are preformed to finish the cell. As mentioned, many alternatives are possible. For example, instead of adding dopant in surface layers the original substrate, doped layers may be deposited on the originals substrate. As another example, instead of adding dopant in a patterned way in unmasked areas of a pattern, doped material may be removed in a patterned way etc.

In an embodiment, measures my be taken to avoid, or minimize the width of regions of intrinsic conductivity at the front and/or back surface, or to minimize their effect. This may be done by providing for barriers between first and second further regions 18a,b at the front surface, for example in the form of parts of semi-conductor substrate with its original doping density. This can be realized by etching away the layer of one of the conductivity types and applying the layer of the other conductivity type in where the layer of the one of the conductivity types has been etched away, or by deposition leaving spacer regions between regions in which enhanced first conductivity type doping is added and regions where second conductivity type doping is added.

In the embodiment wherein the patterned external field generation structure on the front surface is used, the process may comprise a step of creating a pattern of enhanced doped regions of the same conductivity type as semi-conductor substrate 10 at the surface of the substrate, at positions overlying (present or future emitter regions on the back surface). Subsequently a charged layer is deposited on the front surface. Processes for creating of a pattern of enhanced doped regions is known per se.

In an embodiment a surface texture may be created at the front surface, for example by means of anisotropic etching techniques that etch preferentially along predetermined crystal planes. Thus a pyramid structure can be obtained.

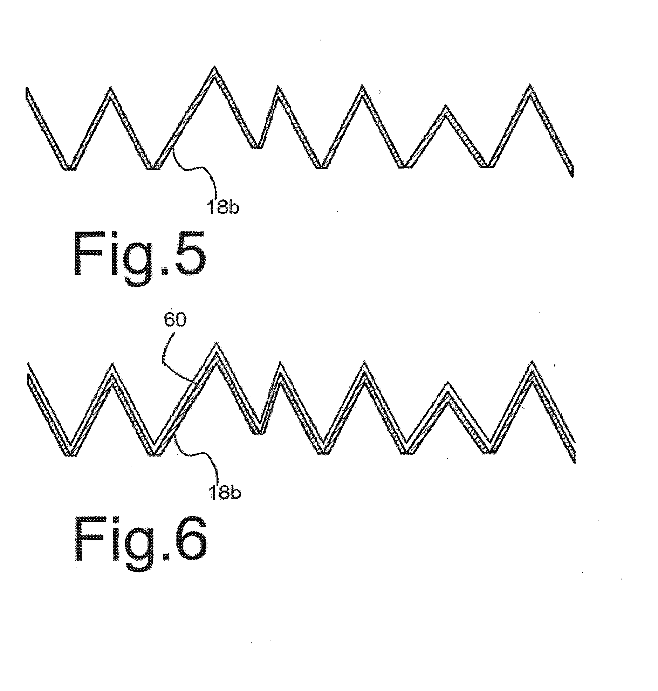

Figure 5 shows a schematic side view of the front surface in an embodiment of a photo-voltaic cell with a surface texture. The surface texture may have an average peak to valley height difference in a range of 1 - 20micron for example, that is, the average difference between the distance from the bottom of the valleys of the texture to the back surface and the distance from the adjacent peaks to the back surface be in this range. Second further region 18b may have a thickness within in a range of 0.1 - 10 micron, which may be smaller than the average peak to valley height difference.

In this cell the second further region 18b is sloped according to the slopes of the textured surface. At the bottom of the valleys this may give rise to local areas without sufficient doping to create a conductivity of the second conductivity type, or the doping density of the second conductivity type may at least be locally lower at the bottoms of the valleys. That is, holes arise in the floating emitter layer realized by second further regions 18b. In this case the lateral current of the majority charge carriers of second further region 18b may be hampered This may reduce the efficiency gain.

Figure 6 illustrates an embodiment wherein the semi-conductor substrate has n-type conductivity and wherein this effect has been reduced by depositing a first layer 60 of aluminium oxide on the front surface after the texturing step and the creation of second further region 18b. The aluminium oxide layer provides for fixed negative charge over the second further regions 18b.This has the effect of driving away mobile electrons from the surface, and attracting mobile holes, making the holes majority charge carriers at the surface, even at locations wherein the p-doped layer of the second further regions 18b may be punctured such as in valleys of the texture. Furthermore the aluminium oxide layer enhances lateral conductivity.

Furthermore a second layer of silicon nitride oxide is created on the front surface over the first further regions 18a (this second layer may be created selectively over these regions, or over the entire front surface).

Figure 7 shows a top view of the front surface of an embodiment of the photovoltaic cell wherein conductor lines 70 (only one labeled) have been added coupled to second further region 18b, extending in the width direction, or at least not perpendicularly to it. Conductor lines 70 provide for an additional current path for the majority charge carriers of second further region 18b in parallel with second further region 18b. This reduces the electric field build-up across the junction between semi-conductor substrate 10 and second further region 18b with increasing distance from the edges of second further region 18b. As a result a higher lateral current along second further region 18b is made possible. This effect is optimized when conductor lines 70 extend perpendicularly from the edge of second further region 18b, but the improvement decreases only gradually with deviation from perpendicular extension. For example, if the angle of conductor lines 70 with the edge of second further region 18b is between forty five and a hundred and thirty five at least seventy percent of the effect is achieved. The width of conductor lines 70 and the distance between these lines may be selected so that only a fraction of the front surface will be covered by conductor lines 70. Therefore it is possible to use conductor lines that are not optically transparent without large loss of incoming light. Alternatively, a patterned transparent conductor layer (TCO) may be used on second further regions. In this case there is no need to use individual conductor lines.

Any one conductor line 70 will already reduce loss due to resistance against lateral current, but the added contribution of additional conductor lines 70 decreases when the distance between successive conductor lines 70 on a second further region 18b becomes smaller than the distance from the central axis of the second further region 18b to its edges. Conductor lines 70 of any width will already reduce loss due to resistance against lateral current, but the added contribution of increased width decreases when once the width is sufficient to provide a conductor line 70 with a resistance that is less than the resistance of second further region 18b between successive conductor lines 70.

As described, a photovoltaic cell is provided with a semi-conductor substrate having base and emitter regions on its back surface, and a pattern of electrically floating regions of the same conductivity type as the emitter regions, but located on the front surface. The floating regions may be called floating emitter regions. They are electrically floating in the sense that electrical current can flow in and out of these regions only through the material of the bulk of the semiconductor substrate (no vias). The emitter regions on the back side and the floating emitter regions on the front side have a conductivity type opposite to that of the bulk of the semi-conductor substrate. The electrically floating emitter regions provide for a current channel for lateral current of charge carriers than form the minority bulk of the semi-conductor substrate at the edges of the electrically floating emitter regions this current crosses over to the emitter regions on the back side. This makes it possible to use wider base regions with less efficiency loss due to electrical shading and limited loss during charging of the floating emitter regions.

The floating emitter regions may be realized by doping with the opposite conductivity type compared to that of the bulk, the doping be located in a surface layer of the semi-conductor substrate or a surface layer on this substrate. Alternatively, or in addition, the floating emitter regions may be realized by means of a patterned external field generation layer on the front surface. In an embodiment, a part of the front surface that is not covered by the floating emitter regions may be a front surface field region, having enhanced conductivity of the same type as the bulk of the semi-conductor substrate.

## Claims

1. A photo-voltaic cell comprising
- first and second output terminals (16a,16b);
- a semiconductor substrate (10) having a first conductivity type, having first and second surface facing each other;
- a first pattern of base (12) and emitter (14) surface regions on the first surface, the base and emitter surface regions being coupled to the first and second output terminals (16a,16b), respectively, the base and emitter surface regions having the first conductivity type and a second conductivity type opposite to the first conductivity type respectively;
- a second pattern of first and second further surface regions (18a,18b) on the second surface, electrically floating with respect to the first and second output terminals, the first and second further surface regions having the first and second conductivity type respectively, the first and second further surface regions at least partly overlapping the emitter and base regions respectively, when seen in a projection along a direction perpendicular to the first surface.

2. A photo-voltaic cell according to claim 1, comprising a patterned semi-conductor layer with net doping of the second conductivity type on or in the semiconductor substrate at the second surface, the patterned semi-conductor layer forming the second further surface regions.

3. A photo-voltaic cell according to any one of the preceding claims, comprising a patterned external field generation structure (300) on the second surface overlying the locations of the second further surface regions, with a field polarity for causing conductivity type inversion at the second surface.

4. A photo-voltaic cell according to claim 3, wherein the patterned external field generation structure comprises a charged layer (302).

5. A photo-voltaic cell according to claim 4, wherein the semiconductor substrate has n-type conductivity and the charged layer is an aluminium oxide or hafnium oxide layer or the semiconductor substrate has p-type conductivity and the charged layer is a silicon nitride or silicon oxide layer.

6. A photo-voltaic cell according to any one of the preceding claims, wherein the second further surface regions completely overlap the base regions, when seen in a projection along a direction perpendicular to the first surface.

7. A photo-voltaic cell according to claim 6, wherein the second further surface regions extend beyond edges of the base regions to locations overlapping the emitter regions, when seen in a projection along a direction perpendicular to the first surface

8. A photo-voltaic cell according to claim 6 or 7, wherein the overlap of the second further surface regions with the emitter regions, if any, has an overlap area of less than ten percent of an area of the emitter region.

9. A photo-voltaic cell according to any one of the preceding claims, wherein the base regions each have a width of at least 0.5 millimeter in their narrowest direction.

10. A photo-voltaic cell according to any one of the preceding claims, comprising an electrically floating conductor line on at least one of the second further surface regions, extending transverse to an edge of the second further surface region.

11. A photo-voltaic cell according to any one of the preceding claims, wherein the second surface has textured height variations, and external field generation layer on the textured structure on the second surface in the second further surface regions.

12. A photo-voltaic cell according to any one of the preceding claims, wherein the first further surface regions have enhanced net doping of the first conductivity type relative to the semi-conductor substrate.

13. A method of manufacturing a photo-voltaic cell, the method comprising
- providing a semi-conductor substrate (10) having first and second surface facing each other, the semi-conductor substrate having a first conductivity type;
- creating a first pattern of base (12) and emitter surface (14) regions on the first surface, the base and emitter surface regions having the first conductivity type and a second conductivity type opposite to the first conductivity type respectively;
- creating a second pattern of further first and second surface regions (18a,18b) on the second surface, the first and second further surface regions having the first and second conductivity type respectively, the first and second further surface regions at least partly overlapping the emitter regions and the base regions respectively, when seen in a projection along a direction perpendicular to the first surface;
- applying first conductor lines on the base regions and emitter regions respectively;
- creating first and second contact areas in electrical connection to the first and second conductor lines respectively, leaving first and second further surface regions electrically floating relative to the first and second contact areas at least in the completed photo-voltaic cell.

14. A method according to claim 13, comprising applying an electrically floating conductor line on at least one of the second further surface regions, extending transverse to an edge of the second further surface region.

15. A method according to claim 13 or 14, comprising texturing the second surface, creating the second further surface regions on the textured second surface, applying an external field generation regions with fixed charge of the first conductivity on at least the second further surface regions.

16. A method of manufacturing a photo-voltaic cell, the method comprising
- providing a semi-conductor substrate (10) having first and second surface facing each other, the semi-conductor substrate having a first conductivity type;
- creating a first pattern of base (12) and emitter surface (14) regions on the first surface, the base and emitter surface regions having the first conductivity type and a second conductivity type opposite to the first conductivity type respectively;
- creating a second pattern of external field generation regions (300) with fixed charge of the first conductivity type on the second surface, the external field generation regions at least partly overlapping the base regions, when seen in a projection along a direction perpendicular to the first surface, leaving first further surface regions on the second surface uncovered by the external field generation regions, the first further surface regions having the first conductivity type;
- applying first and conductor lines on the base regions and emitter regions respectively;
- creating first and second contact areas in electrical connection to the first and second conductor lines respectively.

## Patentansprüche

1. Fotovoltaikzelle, umfassend:
- erste und zweite Ausgangsanschlüsse (16a, 16b);
- ein Halbleitersubstrat (10) mit einem ersten Leitfähigkeitstyp, mit ersten und zweiten einander gegenüberliegenden Oberflächen;
- ein erstes Muster von Basis- (12) und Emitter (14)-Oberflächenregionen auf der ersten Oberfläche, wobei die Basis- und Emitter-Oberflächenregionen an den ersten bzw. zweiten Ausgangsanschluss (16a, 16b) gekoppelt sind, wobei die Basis- und Emitter-Oberflächenregionen den ersten Leitfähigkeitstyp und einen zweiten Leitfähigkeitstyp jeweils gegenüber dem ersten Leitfähigkeitstyp haben;
- ein zweites Muster von ersten und zweiten weiteren Oberflächenregionen (18a, 18b) auf der zweiten Oberfläche, elektrisch schwebend (engl. floating) in Bezug auf die ersten und zweiten Ausgangsanschlüsse, wobei die ersten und zweiten weiteren Oberflächenregionen den ersten bzw. zweiten Leitfähigkeitstyp haben, die ersten und zweiten weiteren Oberflächenregionen die Emitter- bzw. Basisregionen mindestens teilweise überlappen, betrachtet in einer Projektion entlang einer Richtung senkrecht zur ersten Oberfläche.

2. Fotovoltaikzelle nach Anspruch 1, umfassend eine gemusterte Halbleiterschicht mit Netz-Dotierung des zweiten Leitfähigkeitstyps auf oder in dem Halbleitersubstrat an der zweiten Oberfläche, wobei die gemusterte Halbleiterschicht die zweiten weiteren Oberflächenregionen bildet.

3. Fotovoltaikzelle nach einem der vorhergehenden Ansprüche, umfassend eine gemusterte externe Felderzeugungsstruktur (300) auf der zweiten Oberfläche überlagernd die Stellen der zweiten weiteren Oberflächenregionen, mit einer Feldpolarität, um eine Umkehrung des Leitfähigkeitstyps an der zweiten Oberfläche zu bewirken.

4. Fotovoltaikzelle nach Anspruch 3, wobei die gemusterte externe Felderzeugungsstruktur eine geladene Schicht (302) umfasst.

5. Fotovoltaikzelle nach Anspruch 4, wobei das Halbleitersubstrat eine Leitfähigkeit vom n-Typ hat und die geladene Schicht eine Aluminiumoxid- oder Hafniumoxidschicht ist oder das Halbleitersubstrat eine Leitfähigkeit vom p-Typ hat und die geladene Schicht eine Silikonnitrid- oder Silikonoxidschicht ist.

6. Fotovoltaikzelle nach einem der vorhergehenden Ansprüche, wobei die zweiten weiteren Oberflächenregionen die Basisregionen vollständig überlappen, betrachtet in einer Projektion entlang einer Richtung senkrecht zur ersten Oberfläche.

7. Fotovoltaikzelle nach Anspruch 6, wobei die zweiten weiteren Oberflächenregionen über die Ränder der Basisregionen hinaus zu Stellen verlaufen, welche die Emitterregionen überlappen, betrachtet in einer Projektion entlang einer Richtung senkrecht zur ersten Oberfläche.

8. Fotovoltaikzelle nach Anspruch 6 oder 7, wobei die Überlappung der zweiten weiteren Oberflächenregionen mit den Emitterregionen, falls vorhanden, einen Überlappungsbereich von weniger als zehn Prozent eines Bereichs der Emitterregion hat.

9. Fotovoltaikzelle nach einem der vorhergehenden Ansprüche, wobei die Basisregionen jeweils eine Breite von mindestens 0,5 Millimeter in ihrer schmalsten Richtung haben.

10. Fotovoltaikzelle nach einem der vorhergehenden Ansprüche, umfassend eine elektrisch schwebende Stromschiene auf mindestens einer der zweiten weiteren Oberflächenregionen, die quer zu einem Rand der zweiten weiteren Oberflächenregion verläuft.

11. Fotovoltaikzelle nach einem der vorhergehenden Ansprüche, wobei die zweite Oberfläche texturierte Höhenabweichungen und eine externe Felderzeugungsschicht auf der texturierten Struktur auf der zweiten Oberfläche in den zweiten weiteren Oberflächenregionen hat.

12. Fotovoltaikzelle nach einem der vorhergehenden Ansprüche, wobei die ersten weiteren Oberflächenregionen verbesserte Netz-Dotierungen des ersten Leitfähigkeitstyps in Bezug auf das Halbleitersubstrat haben.

13. Verfahren zur Herstellung einer Fotovoltaikzelle, umfassend:
- die Bereitstellung eines Halbleitersubstrats (10) mit ersten und zweiten einander gegenüberliegenden Oberflächen, wobei das Halbleitersubstrat einen ersten Leitfähigkeitstyp hat;
- die Schaffung eines ersten Musters von Basis- (12) und Emitter (14)-Oberflächenregionen auf der ersten Oberfläche, wobei die Basis- und Emitter-Oberflächenregionen den ersten Leitfähigkeitstyp bzw. einen zweiten Leitfähigkeitstyp gegenüber dem ersten Leitfähigkeitstyp haben;
- die Schaffung eines zweiten Musters von weiteren ersten und zweiten Oberflächenregionen (18a, 18b) auf der zweiten Oberfläche, wobei die ersten und zweiten weiteren Oberflächenregionen den ersten bzw. zweiten Leitfähigkeitstyp haben, wobei die ersten und zweiten weiteren Oberflächenregionen die Emitterregionen bzw. die Basisregionen mindestens teilweise überlappen, betrachtet in einer Projektion entlang einer Richtung senkrecht zur ersten Oberfläche;
- die Anwendung von ersten Stromschienen auf den Basis- bzw.
Emitterregionen;
- die Schaffung von ersten und zweiten Kontaktbereichen in elektrischer Verbindung mit den ersten bzw. zweiten Stromschienen, wobei die ersten und zweiten weiteren Oberflächenregionen, zumindest in der fertiggestellten Fotovoltaikzelle, elektrisch schwebend zu den ersten und zweiten Kontaktbereichen bleiben.

14. Verfahren nach Anspruch 13, umfassend die Anwendung einer elektrisch schwebenden Stromschiene auf mindestens einer der zweiten weiteren Oberflächenregionen, verlaufend quer zu einem Rand der zweiten weiteren Oberflächenregion.

15. Verfahren nach Anspruch 13 oder 14, umfassend die Texturierung der zweiten Oberfläche, die Schaffung der zweiten weiteren Oberflächenregionen auf der texturierten zweiten Oberfläche, die Anwendung einer externen Felderzeugungsregion mit fester Ladung der ersten Leitfähigkeit auf mindestens den zweiten weiteren Oberflächenregionen.

16. Verfahren zur Herstellung einer Fotovoltaikzelle, umfassend:
- die Bereitstellung eines Halbleitersubstrats (10) mit ersten und zweiten einander gegenüberliegenden Oberflächen, wobei das Halbleitersubstrat einen ersten Leitfähigkeitstyp hat;
- die Schaffung eines ersten Musters von Basis- (12) und Emitter (14)-Oberflächenregionen auf der ersten Oberfläche, wobei die Basis- und Emitter-Oberflächenregionen den ersten Leitfähigkeitstyp bzw. einen zweiten Leitfähigkeitstyp gegenüber dem ersten Leitfähigkeitstyp haben;
- die Schaffung eines zweiten Musters von externen Felderzeugungsregionen (300) mit fester Ladung des ersten Leitfähigkeitstyps auf der zweiten Oberfläche, wobei die externen Felderzeugungsregionen die Basisregionen mindestens teilweise überlappen, betrachtet in einer Projektion entlang einer Richtung senkrecht zur ersten Oberfläche, wobei die ersten weiteren Oberflächenregionen auf der zweiten Oberfläche von den externen Felderzeugungsregionen unbedeckt bleiben, wobei die ersten weiteren Oberflächenregionen den ersten Leitfähigkeitstyp haben;
- die Anwendung von ersten Stromschienen auf den Basis- bzw. Emitterregionen;
- die Schaffung von ersten und zweiten Kontaktbereichen in elektrischer Verbindung mit den ersten bzw. zweiten Stromschienen.

## Revendications

1. Pile photovoltaïque, comprenant :
des première et deuxième bornes de sortie (16a, 16b) ;
un substrat semi-conducteur (10) ayant un premier type de conductivité, présentant des première et deuxième surfaces opposées l'une à l'autre ;
un premier motif de régions de surface de base (12) et d'émetteur (14) sur la première surface, les régions de surface de base et d'émetteur étant couplées aux première et deuxième bornes de sortie (16a, 16b), respectivement, les régions de surface de base et d'émetteur présentant le premier type de conductivité et un second type de conductivité opposé au premier type de conductivité, respectivement ; et
un deuxième motif de premières et deuxièmes régions de surface supplémentaires (18a, 18b) sur la deuxième surface, flottant électriquement par rapport aux première et deuxième bornes de sortie, les premières et deuxièmes régions de surface supplémentaires présentant les premier et second types de conductivité, respectivement, les premières et deuxièmes régions de surface supplémentaires recouvrant au moins partiellement les régions d'émetteur et de base, respectivement, lorsque l'on regarde dans une projection le long d'une direction perpendiculaire à la première surface.

2. Pile photovoltaïque selon la revendication 1, comprenant une couche semiconductrice à motifs présentant un dopage net du second type de conductivité sur ou dans le substrat semi-conducteur à la deuxième surface, la couche semiconductrice à motifs formant les deuxièmes régions de surface supplémentaires.

3. Pile photovoltaïque selon l'une quelconque des revendications précédentes, comprenant une structure de génération de champ externe à motifs (300) sur la deuxième surface qui recouvre les endroits des deuxièmes régions de surface supplémentaires, avec une polarité de champ pour entraîner une inversion du type de conductivité à la deuxième surface.

4. Pile photovoltaïque selon la revendication 3, dans laquelle la structure de génération de champ externe à motifs comprend une couche chargée (302).

5. Pile photovoltaïque selon la revendication 4, dans laquelle le substrat semi-conducteur présente une conductivité de type n, et la couche chargée est une couche d'oxyde d'aluminium ou d'oxyde de hafnium, ou le substrat semi-conducteur présente une conductivité de type p et la couche chargée est une couche de nitrure de silicium ou d'oxyde de silicium.

6. Pile photovoltaïque selon l'une quelconque des revendications précédentes, dans laquelle les deuxièmes régions de surface supplémentaires recouvrent complètement les régions de base, lorsque l'on regarde dans une projection le long d'une direction perpendiculaire à la première surface.

7. Pile photovoltaïque selon la revendication 6, dans laquelle les deuxièmes régions de surface supplémentaires s'étendent au-delà des bords des régions de base jusqu'à des endroits qui recouvrent les régions d'émetteur, lorsque l'on regarde dans une projection le long d'une direction perpendiculaire à la première surface.

8. Pile photovoltaïque selon la revendication 6 ou 7, dans laquelle le recouvrement des deuxièmes régions de surface supplémentaires avec les régions d'émetteur, le cas échéant, présente une surface de recouvrement qui est inférieure à 10 % d'une surface de la région d'émetteur.

9. Pile photovoltaïque selon l'une quelconque des revendications précédentes, dans laquelle les régions de base présentent chacune une largeur d'au moins 0,5 millimètre dans leur direction la plus étroite.

10. Pile photovoltaïque selon l'une quelconque des revendications précédentes, comprenant une ligne conductrice électriquement flottante sur au moins une des deuxièmes régions de surface supplémentaires, qui s'étend transversalement jusqu'à un bord de la deuxième région de surface supplémentaire.

11. Pile photovoltaïque selon l'une quelconque des revendications précédentes, dans laquelle la deuxième surface présente des variations de la hauteur texturée, et une couche de génération de champ externe sur la structure texturée sur la deuxième surface dans les deuxièmes régions de surface supplémentaires.

12. Pile photovoltaïque selon l'une quelconque des revendications précédentes, dans laquelle les premières régions de surface supplémentaires présentent un dopage net amélioré du premier type de conductivité par rapport au substrat semi-conducteur.

13. Procédé de fabrication d'une pile photovoltaïque, le procédé comprenant les étapes suivantes :
- fournir un substrat semi-conducteur (10) présentant des première et deuxième surfaces opposées l'une à l'autre, le substrat semi-conducteur présentant un premier type de conductivité ;
- créer un premier motif de régions de surface de base (12) et d'émetteur (14) sur la première surface, les régions de surface de base et d'émetteur présentant le premier type de conductivité et un second type de conductivité opposé au premier type de conductivité, respectivement ;
- créer un deuxième motif de premières et deuxièmes régions de surface supplémentaires (18a, 18b) sur la deuxième surface, les premières et deuxièmes régions de surface supplémentaires présentant les premier et deuxième types de conductivité, respectivement, les premières et deuxièmes régions de surface supplémentaires recouvrant au moins partiellement les régions d'émetteur et les régions de base, respectivement, lorsque l'on regarde dans une projection le long d'une direction perpendiculaire à la première surface ;
- appliquer des premières lignes conductrices sur les régions de base et les régions d'émetteur, respectivement ; et
- créer des première et deuxième zones de contact en connexion électrique avec les première et deuxième lignes conductrices, respectivement, en laissant les premières et deuxièmes régions de surface supplémentaires flotter électriquement par rapport aux première et deuxième zones de contact au moins dans la cellule photovoltaïque terminée.

14. Procédé selon la revendication 13, comprenant l'application d'une ligne conductrice électriquement flottante sur au moins une des deuxièmes régions de surface supplémentaires, qui s'étend transversalement jusqu'à un bord de la deuxième région de surface supplémentaire.

15. Procédé selon la revendication 13 ou 14, comprenant la texturation de la deuxième surface, la création des deuxièmes régions de surface supplémentaires sur la deuxième surface texturée, et l'application de régions génératrices de champ externe présentant une charge fixe de la première conductivité sur au moins les deuxièmes régions de surface supplémentaires.

16. Procédé de fabrication d'une pile photovoltaïque, le procédé comprenant les étapes suivantes :
- fournir un substrat semi-conducteur (10) présentant des première et deuxième surfaces opposées l'une à l'autre, le substrat semi-conducteur présentant un premier type de conductivité ;
- créer un premier motif de régions de surface de base (12) et d'émetteur (14) sur la première surface, les régions de surface de base et d'émetteur présentant le premier type de conductivité et un second type de conductivité opposé au premier type de conductivité, respectivement ;
- créer un deuxième motif de régions de génération de champ externe (300) présentant une charge fixe du premier type de conductivité sur la deuxième surface, les régions de génération de champ externe recouvrant au moins partiellement les régions de base, lorsque l'on regarde dans une projection le long d'une direction perpendiculaire à la première surface, en laissant les premières régions de surface supplémentaires sur la deuxième surface non couvertes par les régions de génération de champ externe, les premières régions de surface supplémentaires présentant le premier type de conductivité ;
- appliquer des premières lignes conductrices sur les régions de base et les régions d'émetteur, respectivement ; et
- créer des première et deuxième zones de contact en connexion électrique avec les première et deuxième lignes conductrices, respectivement.
